(19) Europäisches Patentamt
European Patent Office
Office européen des brevets

(11) **EP 4 733 842 A1**

(12) **EUROPEAN PATENT APPLICATION**

(43) Date of publication:
**29.04.2026 Bulletin 2026/18**

(21) Application number: **24208824.3**

(22) Date of filing: **25.10.2024**

(51) International Patent Classification (IPC):
***G03F 7/20*** (2006.01)  ***G03F 7/00*** (2006.01)

(52) Cooperative Patent Classification (CPC):
**G03F 7/7085; G03F 7/70516; G03F 7/706**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **MOHAMMED, Mahir, Asif**
  **5500 AH Veldhoven (NL)**
• **SCHOLTEN, Bert, Dirk**
  **5500 AH Veldhoven (NL)**

(74) Representative: **ASML Netherlands B.V.**
**Corporate Intellectual Property**
**P.O. Box 324**
**5500 AH Veldhoven (NL)**

Remarks:
Claims 16-19 are deemed to be abandoned due to non-payment of the claims fees (Rule 45(3) EPC).

(54) **METHOD FOR DETERMINING A REFRACTIVE INDEX OF A MEMBRANE**

(57) Method of determining a refractive index of a membrane associated with an image sensor, the method comprising the steps of obtaining a first diffraction pattern of a first patterned membrane section, the first patterned membrane section having a first membrane-to-open ratio, and obtaining a second diffraction pattern of a second patterned membrane section, the second patterned membrane section having a second membrane-to-open ratio, the second membrane-to-open ratio being different from the first membrane-to-open ratio, and determining a refractive index of the membrane based on the first diffraction pattern and the second diffraction pattern.

Fig. 8

EP 4 733 842 A1

**Description**

FIELD

The present invention relates to a method of determining a refractive index of a membrane associated with an image sensor and to a lithographic apparatus configured for determining a refractive index of a membrane associated with an image sensor.

BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses a reflective surfaces instead of a lenses as optics. Mask blanks used in EUV lithography generally have a multilayer structure which functions as a Bragg reflector, the multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Forth, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

The lithographic apparatus generally uses one or more image sensors, e.g. for substrate aligning purposes. An image sensor may measure a wavefront aberration of a projection system and the projection system, e.g. one or more mirrors, can be adjusted to sharpen the image. The image sensor may comprise a detector and an associated membrane. The membrane has a refractive index that affects the measurements of the detector, and thereby the output of the image sensor. A bias error can be caused by a phase delay of the EUV light passing through the membrane. It is therefore desired to accurately know the refractive index of the membrane in order to be able to correct for the associated bias error of the image sensor.

SUMMARY

According to an aspect of the invention, there is provided a method of determining a refractive index of a membrane associated with an image sensor, the method comprising the steps of:

a) obtaining a first diffraction pattern of a first patterned membrane section, the first patterned membrane section having a first membrane-to-open ratio, and obtaining a second diffraction pattern of a second patterned membrane section, the second patterned membrane section having a second membrane-to-open ratio, the second membrane-to-open ratio being different from the first membrane-to-open ratio,
b) determining a refractive index of the membrane based on the first diffraction pattern and the second diffraction pattern.

In another aspect of the invention, there is provided an image sensor system comprising:

- an image sensor comprising a detector;
- a membrane associated with the image sensor, wherein the membrane comprises a first patterned membrane section and a second patterned membrane section, wherein the first patterned membrane section has a first membrane-to-open ratio, and wherein the second patterned membrane section has a second membrane-to-open ratio, the second membrane-to-open ratio being different from the first membrane-to-open ratio,

wherein the detector is configured to, when the membrane is irradiated with a radiation beam, detect a first signal indicative of a first diffraction pattern of the first patterned membrane section, and to detect a second signal indicative of a second diffraction pattern of the second patterned membrane,
and wherein the detector is configured to provide the first signal and the second signal to a control system for determining the refractive index.

In another aspect of the invention, there is provided a substrate stage comprising an image sensor system.

In another aspect of the invention, there is provided a lithographic apparatus configured for determining a refractive index of a membrane associated with an image sensor.

BRIEF DESCRIPTION OF THE DRAWINGS

Embodiments of the invention will now be described, by way of example only, with reference to the accompanying schematic drawings, in which:

- Figure 1 schematically depicts a lithographic system comprising a lithographic apparatus and a radiation source;

- Figure 2 schematically depicts a system for (actinic) mask inspection;

- Figure 3 schematically depicts a top view of a substrate table comprising an image sensor;

- Figure 4 schematically depicts an embodiment of a system comprising an image sensor comprising a membrane;

- Figure 5A schematically depicts, in top view, an embodiment of a first patterned membrane section;

- Figure 5B schematically depicts, in top view, an embodiment of a second patterned membrane section;

- Figure 6A schematically depicts, in cross-sectional side view, the first patterned membrane section as shown in figure 5A through section A-A;

- Figure 6B schematically depicts, in cross-sectional side view, the first patterned membrane section as shown in figure 5B through section B-B;

- Figure 7A schematically depicts a first diffraction pattern associated with the first patterned membrane section as shown in figure 5A;

- Figure 7B schematically depicts a second diffraction pattern associated with the second patterned membrane section as shown in figure 5B;

- Figure 8 schematically depicts, in top view, another embodiment of a first patterned membrane section and a second patterned membrane section;

- Figure 9 depicts an exemplary graph showing a shift in peak interference peaks between the diffraction patterns associated with the first patterned membrane section and the second patterned membrane section;

- Figure 10 schematically depicts, in top view, an embodiment of a membrane comprising a first patterned membrane section and a second patterned membrane section;

- Figure 11 schematically depicts, in cross-sectional side view, a section of the membrane as shown in figure 9;

- Figure 12 depicts an exemplary graph showing a shift in peak interference peaks between the diffraction patterns associated with the first patterned membrane section and the second patterned membrane section for the example shown in figure 9.

DETAILED DESCRIPTION

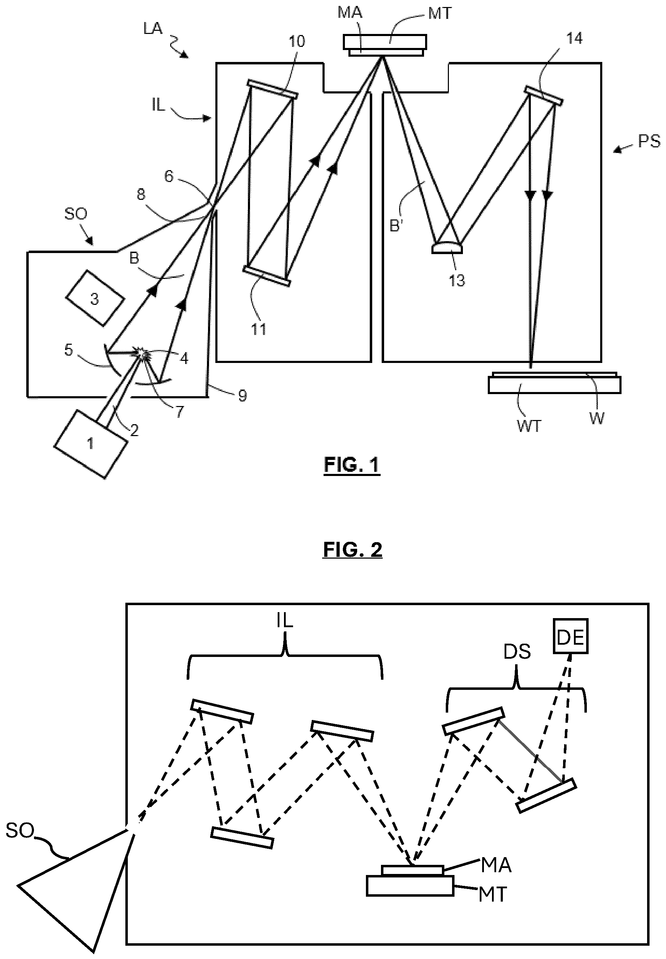

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

Figure 2 depicts a system for (actinic) mask inspection. A mask inspection system can be used to identify or inspect defects in a mask to be used in a lithographic process by means of an lithographic system described in Figure 1. The mask inspection system comprises a radiation source SO and an illumination system IL and a detection system DS. A patterning device (i.c. mask) MA is placed on a support structure MT, which may be a mask stage, and illuminated by the illumination system IL reflecting radiation incident from the radiation source SO. The radiation coming from the illuminated patterning device MA is reflected by the detection system. In this way an image is formed on a detector DE. The radiation source SO of Figure 2 may be modelled after the radiation source system of Figure 1.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel (i.e., a target material), such as tin (Sn) which is provided from, e.g., a fuel generator 3. Although tin is referred to in the following description, any suitable fuel may be used. The fuel may, for example, be in liquid form, and may, for example, be a metal or alloy. The fuel generator 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a free electron laser (FEL) or a discharge produced plasma (DPP) source may be used to generate EUV radiation.

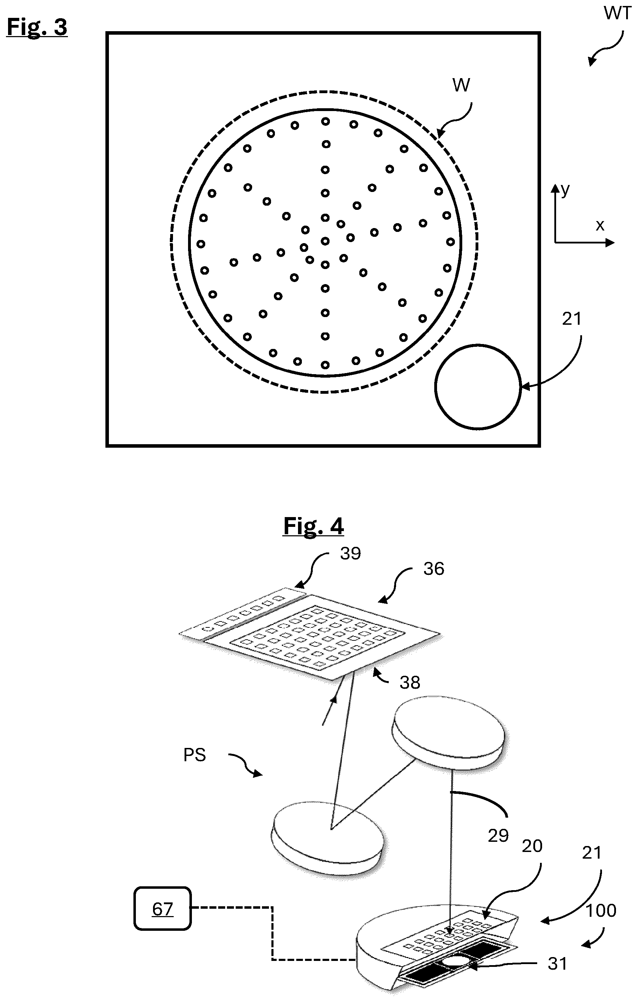

Figure 3 schematically depicts an example of a substrate table WT as shown in figure 1. An image sensor 21 may be provided on the substrate table WT, for example for aligning purposes, i.e. aligning of a substrate W on the substrate table WT. In the shown examples the image sensor 21 and the associated membrane 20 are located in a lithographic apparatus. The image sensor 21 and associated membrane 20 may also be provided in different apparatus.

Figure 4 shows the image sensor 21 which is irradiated by a radiation beam 29, e.g. a monochromatic radiation beam. This can be a radiation beam B or patterned radiation beam B' as shown in figure 1. The radiation beam 29 may be an EUV light radiation beam. The radiation beam may have a single illumination angle. When the radiation beam has a plurality of illumination angles close to the chief angle the obtained diffraction patterns may be less sharp, or blurry. Prior to irradiating the image sensor 21, the radiation beam 29 is reflected from a reflective member, e.g. a reticle 36 or a patterning device MA or a fiducial 39, after which it propagates through a projection system PS, e.g. comprising one or more mirrors. The projection system PS may also be referred to as a projection optics box.

Figure 4 further shows an embodiment of an image sensor system 100 comprising an image sensor 21 and a membrane 20 that is associated with the image sensor 21. The image sensor 21 comprises a detector 31 which is located downstream of the membrane 20 when viewed along the path of the radiation beam 29. The detector may be configured to provide signals to a control system 67.

The membrane 20 has a refractive index. Accurate knowledge of the refractive index is important for determining the accuracy of the image sensor 21. Inaccurate knowledge of the refractive index can lead to an unaccounted bias error for the image sensor 21.

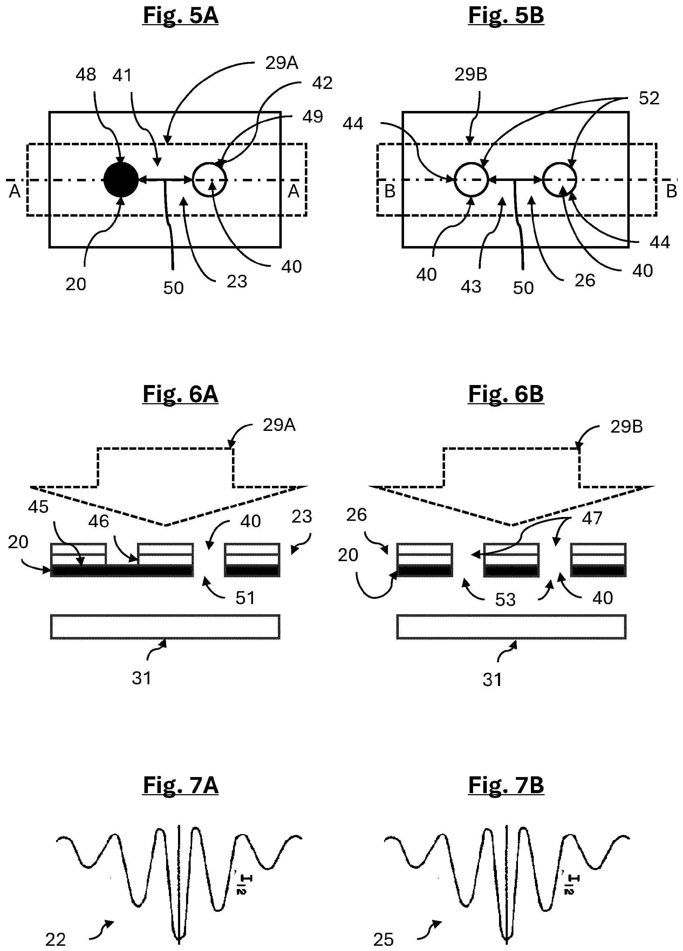

A method of determining the refractive index of the membrane 20 associated with the image sensor 21 comprises obtaining a first diffraction pattern 22 (as for example shown figure 7A) of a first patterned membrane section 23 (see e.g. figure 5A) and obtaining a second diffraction pattern 25 (as for example shown in figure 7B) of a second patterned membrane section 26 (see e.g. figure 5B). The first patterned membrane section 23 has a first membrane-to-open ratio. The second patterned membrane section 26 has a second membrane-to-open ratio. The second membrane-to-open ratio is different from the first membrane-to-open ratio. The membrane-to-open ratio can be considered the area of membrane 20 that is irradiated over the area of openings (i.e. through holes) irradiated.

In an embodiment, the membrane 20 is a thin film having a plurality of membrane openings 40 therein. The membrane openings 40 may be circular pinholes with a diameter of 8nm to 3$\mu$m. The thin film may for example be an aluminium nitride film. Other material are also possible, e.g. Silicon Nitride, Chrome or Aluminium Oxide. The membrane 20 comprises the first patterned membrane section 23 and a second patterned membrane section 26, see the examples of figures 5A, 5B, 8 and 10. The first patterned membrane section 23 is formed by at least a first film surface area 41 and a first membrane openings area 42. The second patterned membrane section 26 is formed by at least a second film surface area 43 and a second membrane openings area 44. The first membrane-to-open ratio is defined by the ratio between an exposed part of the first film surface area 41 and the first membrane openings area 42. The second membrane-to-open ratio is defined by the ratio between an exposed part of the second film surface area 43 and the second membrane openings area 44. The exposed parts are the parts of the first patterned membrane section 23 and second patterned membrane section 26 that are irradiated directly by the radiation beam 29.

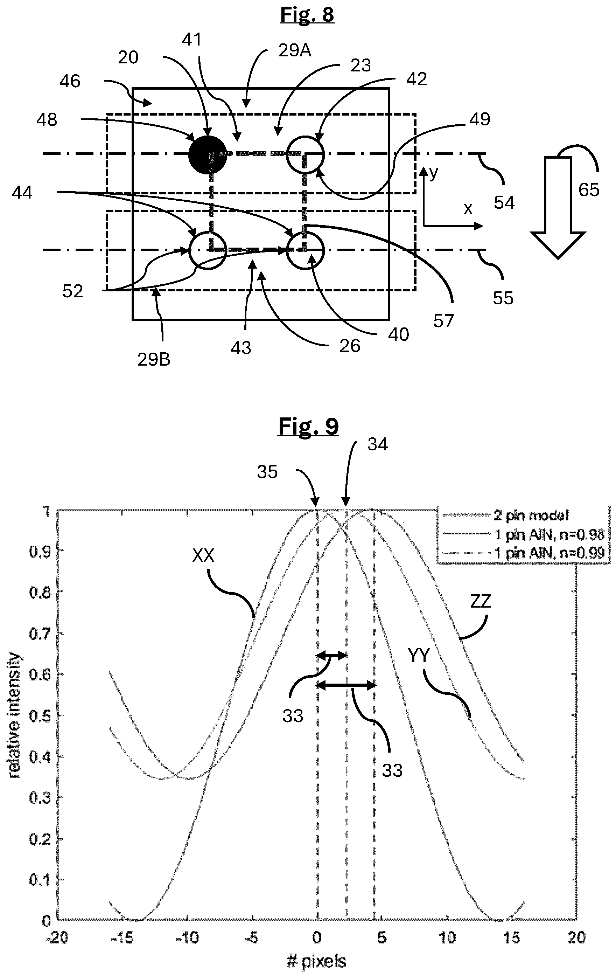

In the examples of figures 5A, 5B and 8 the thin film membrane 20 has a top surface 45 that is covered with an isolation layer 46. Parts of the first film surface and second film surface that are covered by the isolation layer 46 are not irradiated directly by the radiation beam 29. The isolation layer 46 may for example comprise Silicon Nitride or Silicon Oxide and may be either reflective or absorptive.

The isolation layer 46 has a plurality of isolation openings 47. In the examples of figures 5A, 6A and of figure 8, a first isolation opening 48 overlays the first film surface that is part of the first patterned membrane section 23, i.e. the exposed part of the first film surface. A first adjacent isolation opening 49 located at a first distance 50 from the first isolation opening 48 overlays one first membrane opening 51 that is part of the first patterned membrane section 23. In the examples of figures 5B, 6B and of figure 8, two adjacent second isolation openings 52 located at the first distance 50 from each other overlay two second membrane openings 53 that are part of the second patterned membrane section 26.

For the examples shown in figures 5A, 5B and 8 the first membrane-to-open ratio is higher than zero, preferably 1:1, and the second membrane-to-open ratio is 0:1.

In order to obtain the first diffraction pattern 22, the first patterned membrane section 23 is irradiated with a radiation beam 29, in the figures also indicated with numeral 29A. Prior to the first radiation beam 29A irradiating the first patterned membrane section 23, the first radiation beam 29A is reflected off a reticle 36, or a fiducial 39, after which the first radiation beam 29A travels through the projection system PS towards the first patterned membrane section 23. The radiation beam 29, or at least a part of the radiation beam 29 travels through the first patterned membrane section 23 and irradiates the detector 31. A first signal is measured, or detected, with the detector 31 of the image sensor 21. The first signal represents the first diffraction pattern 22.

Figures 5B and 6B show an example of a second patterned membrane section 26. Figure 7B schematically shows the second diffraction pattern 25 associated with the second patterned membrane section 26. In order to obtain the second diffraction pattern 25 the second patterned membrane section 26 is irradiated with a radiation beam 29, in the figures also indicated with numeral 29B. Prior to the second radiation beam 29B irradiating the second patterned membrane section 26, the second radiation beam 29B is reflected off the reticle 36, or the fiducial 39, after which the second radiation beam 29B travels through the projection system PS towards the second patterned membrane section 26. The first radiation beam 29A and second radiation beam 29B may be reflected of a same reflection area 38 of the reticle 36 or fiducial 39 for the first patterned membrane section 23 and second patterned membrane section 26. The radiation beam 29, or at least part of the radiation beam 29, travels through the second patterned membrane section 26 and irradiates the detector 31. A second signal is measured, or detected, with the detector 31 of the image sensor 21. The second signal represents the second diffraction pattern 25.

The first patterned membrane section 23 may be irradiated before or after the second patterned membrane section 26 is irradiated. Therefore in the figures numerals 29A and 29B are shown as species of the genus radiation beam 29. It may also be possible to irradiate the first patterned membrane section 23 and the second patterned membrane section at the same time. When irradiating at the same time, the first patterned membrane section 23 and the second patterned membrane section are located at a distance from each other such that the detector can detect the first diffraction pattern and second diffraction pattern distinctly and separately, i.e. without any overlap. This may however require a larger detector.

The radiation beam 29 may be shifted relative to the first patterned membrane section and the second patterned membrane section, and/or the first patterned membrane section and the second patterned membrane section may be shifted relative to the radiation beam 29 for irradiating the first patterned membrane section before or after irradiating the second patterned membrane section.

As shown in the example of figure 8, the first isolation opening 48 and first adjacent isolation opening 49 may be located on a first line 54 and the two adjacent second isolation openings 52 may be located on a second line 55. The second line 55 extends parallel to the first line 54. Each of the first isolation opening 48, the first adjacent isolation opening 49 and the two adjacent second isolation openings 52 is located on a different corner of a rectangular grid 57. This may provide a more accurate measurement and thereby a more accurately determined refractive index, because the radiation beam 29 only has to shift relative to the membrane 20 in one direction 65 perpendicular to the first line 54 in order to irradiate the first patterned membrane section 23 and the second patterned membrane section 26. In the example shown in figure 8 the radiation beam 29 shifts in the Y-direction between the first patterned membrane section 23 and the second patterned membrane section 26.

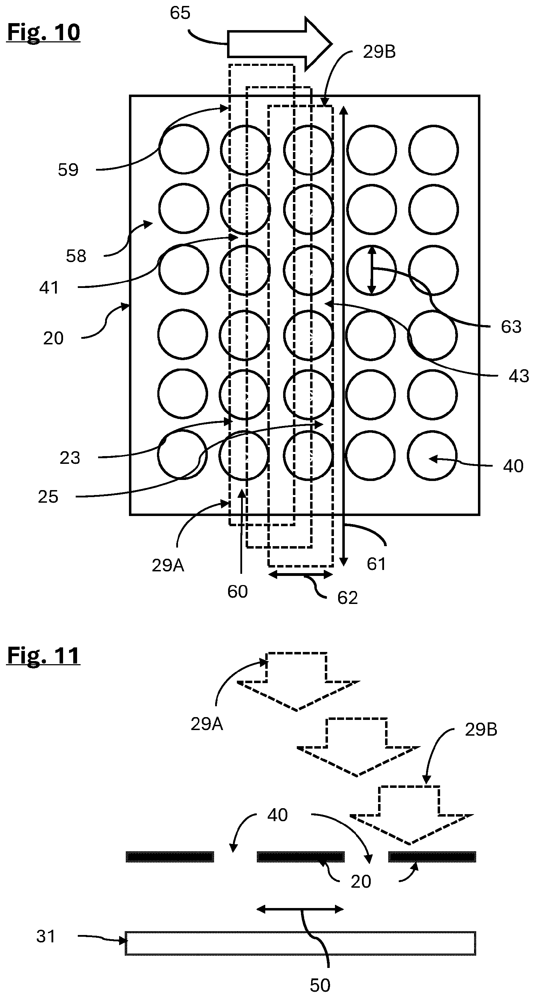

The example of figures 10 and 11 schematically depicts a thin film membrane 20 that is free from other layers. The plurality of membrane openings 40 are arranged in an array 58. The irradiation beam 29, schematically indicated with a rectangle with dashed lines, has a beam projection 59 for overlaying a row 60 of membrane openings 40. The beam projection 59 has a beam width 61 and a beam height 62. The beam width 61 is at least equal to the sum of the first distance 50, i.e. the distance between two adjacent membrane openings 40, and two membrane openings diameters 63. The beam height 62 is at least equal to a membrane opening diameter 63. Obtaining the first diffraction pattern 22 and second diffraction pattern 25 here comprises shifting the beam projection 59 in a direction transverse, preferably perpendicular as indicated by arrow 65. Again, the projection beam shift can be achieved by moving the membrane relative to the radiation beam and/or moving the radiation beam relative to the membrane. Moving the membrane relative to the radiation beam may result in a more accurate determination of the refractive index compared to moving the radiation beam relative to the membrane, because the latter requires movement of for example the reticle and/or the projection system.

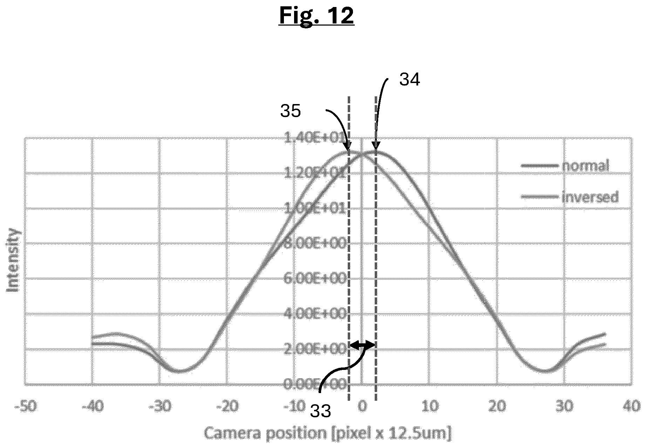

The radiation beam 29, and thereby the beam projection 59, may also be shifted for obtaining a plurality of, here more than two, diffraction patterns. As the projection beam is projected at different areas of the membrane from a first row of pinholes (i.e. the first patterned membrane section), or first set of rows, towards a second row of pinholes (i.e. the second patterned membrane section), or second set of rows, the diffraction pattern will keep shifting. A maximum shift of the second diffraction pattern with respect to the first diffraction pattern can be found when reaching the second radiation beam 29B. The line associated with peak 35 in figure 12 corresponds to the second diffraction pattern, whereas the line associated with peak 34 corresponds to the first diffraction pattern. If one were to continue shifting the projection beam a same distance as between the first patterned membrane section and the second patterned membrane section the first diffraction pattern can be obtained again.

The method further comprises determining the refractive index of the membrane 20 based on the first diffraction pattern 22 and the second diffraction pattern 25.

The step of determining the refractive index comprises measuring an peak phase shift 33 between a first peak interference peak 34 of the first diffraction pattern 22 and a second peak interference peak 35 of the second diffraction pattern 25. In the examples of figures 5A, 5B and 8 the shift happens because of the peak phase shift 33 when light passes through the first isolation opening 48 with membrane, i.e. the exposed first film surface area 41, and interferes with the light that passes through the membrane opening 40 with air or vacuum. Two interference, or diffraction patterns can be plotted 'on top' of each other, after which they are compared to determine the relative shift between the first peak interference peak 34 and the second peak interference peak 35. The relative shift can be directly translated to the refractive index. The peak phase shift is schematically indicated in the graph shown in figure 9, wherein line XX represents the second diffraction pattern 25. The shifted line YY represents the first diffraction pattern 22 for a membrane 20 with a first refractive index (n=0.99) and shifted line ZZ represents a first diffraction pattern 22 for a membrane 20 with a second refractive index (n=0.98). The shift accounts for the membrane's refractive index when deviating from air or vacuum (n=1). When for example using a camera, or detector, with 12.5 μm pixel size, a peak phase shift can be determined equivalent to 0.005 per pixel. 0.005 is not the refractive index but the amount of deviation from the refractive index in air or vacuum. Because the refractive index of air or vacuum is 1, the peak phase shift is due to the presence of the membrane. Therefore the refractive index of the membrane can be formulated as:

$$\text{refractive index membrane} = 1 - (\text{\# of pixels} * 0.005)$$

For the example shown in figures 10 and 11 the peak phase shift 33 between a first peak interference peak 34 of the first diffraction pattern 22 and a second peak interference peak 35 of the second diffraction pattern 25 is indicated in the graph shown in figure 12. The refractive index may, again, be determined based on the amount of pixels associated with the peak phase shift and the above given formula for a camera with a 12.5 μm pixel size.

The method may be performed in situ, e.g. in case of a lithographic apparatus the method may be performed in the lithographic apparatus. The radiation source SO of the lithographic apparatus may be used for the radiation beam 29, which is beneficial because the radiation source is already built in. The method may take ageing of the membrane 20 into account. EUV for example causes degradation by oxidation of the membrane 20 material which can further increase bias error. Also substrate to substate, or wafer to wafer, and die to die variation may be taken into account to correct the bias error. The method may allow for less complex modelling and parameter fitting, which often lead to inaccurate determination of the refractive index of the material.

A lithographic apparatus LA may be configured for determining the refractive index of a membrane 20 associated with an image sensor 21. The lithographic apparatus comprises the image sensor 21 comprising a detector 31, and the membrane 20 associated with the image sensor 21. The membrane 20 comprises the first patterned membrane section 23 and the second patterned membrane section 26. The first patterned membrane section 23 has a first membrane-to-open ratio. The second patterned membrane section 26 has a second membrane-to-open ratio, wherein the second membrane-to-open ratio is different from the first membrane-to-open ratio. The lithographic apparatus comprises a radiation source SO for projecting a radiation beam 29 on the first patterned membrane section 23 and the second patterned membrane section 26. The detector 31 is configured to detect a first signal indicative of a first diffraction pattern 22 of the first patterned membrane section 23, and to detect a second signal indicative of a second diffraction pattern 25 of the second patterned membrane. The image sensor 21 is configured to be coupled to a control system 67 for determining the refractive index of the membrane 20 based on the first diffraction pattern 22 and the second diffraction pattern 25. The control system 67 may be internal to the lithographic apparatus or external.

The refractive index may be part of a machine constant that is updated based on the determined refractive index and the image sensor 21 can take into account the refractive index to determine live bias error.

In general, the image sensor is used to determine characteristics of the projection system, e.g. the position of aerial image of a reticle grating to achieve alignment, or an aberration in the projection system which can then be taken into account / or corrected for. The refractive index is used/needed to accurately determine this characteristic. So the refractive index as determined is then e.g. used in the determination of an aerial image position or an aberration of the projection system...

The image sensor or image sensor system according to the present disclosure may thus be part of a transmission image sensor (TIS) for determining the position of an aerial image in a lithographic apparatus, or may for example be part of a substrate stage.

The image sensor or image sensor system according to the present disclosure may also be part of a phase-stepping measurement system for determining an aberration map of a projection system of a lithographic apparatus. In such measurement system, the membrane may serve as a two-dimensional diffraction grating, e.g. a pinhole grating as schematically shown in Figure 10.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. Method of determining a refractive index of a membrane associated with an image sensor, the method comprising the steps of:

    a) obtaining a first diffraction pattern of a first patterned membrane section, the first patterned membrane section having a first membrane-to-open ratio, and obtaining a second diffraction pattern of a second patterned membrane section, the second patterned membrane section having a second membrane-to-open ratio, the second membrane-to-open ratio being different from the first membrane-to-open ratio,

    b) determining a refractive index of the membrane based on the first diffraction pattern and the second diffraction pattern.

2. Method according to claim 1, wherein obtaining the first diffraction pattern comprises irradiating the first patterned membrane section with a radiation beam and measuring a first signal with a detector of the image sensor, and wherein obtaining the second diffraction pattern comprises irradiating the second patterned membrane section with a radiation beam and measuring a second signal with the detector, the first signal representing the first diffraction pattern and the second signal representing the second diffraction pattern.

3. Method according to claim 2, wherein the first patterned membrane section is irradiated before or after the second patterned membrane section is irradiated.

4. Method according to claim 2 or 3, wherein the radiation beam is shifted relative to the first patterned membrane section and the second patterned membrane section, and/or wherein the first patterned membrane section and the second patterned membrane section are shifted relative to the radiation beam for irradiating the first patterned membrane section before or after irradiating the second patterned membrane section.

5. Method according to any one of the preceding claims, wherein determining the refractive index comprises measuring an peak phase shift between a first peak interference peak of the first diffraction pattern and a second peak interference peak of the second diffraction pattern.

6. Method according to any one of claims 2 - 5, wherein, prior to the first radiation beam irradiating the first patterned membrane section, the first radiation beam is reflected off a reticle after which the first radiation beam travels through a projection system towards the first patterned membrane section, and wherein, prior to the second radiation beam irradiating the second patterned membrane section, the second radiation beam is reflected off the reticle after which the second radiation beam travels through the projections system towards the second patterned membrane section.

7. Method according to the preceding claim, wherein the first radiation beam and second radiation beam are reflected off a same reflection area of the reticle for the first patterned membrane section and second patterned membrane section.

8. Method according to any one of the preceding claims, wherein the membrane is a thin film having a plurality of membrane openings therein, wherein the first patterned membrane section is formed by at least a first film surface area and a first membrane openings area, and wherein the second patterned membrane section is formed by at least a second film surface area and a second membrane openings area, wherein the first membrane-to-open ratio is defined by the ratio between an exposed part of the first film surface area and the first membrane openings area, and wherein the second membrane-to-open ratio is defined by the ratio between an exposed part of the second film surface area and the second membrane openings area.

9. Method according to the preceding claim, wherein the thin film has a top surface that is covered with an isolation layer, the isolation layer having a plurality of isolation openings, wherein a first isolation opening overlays the first film surface, and wherein a first adjacent isolation opening located at a first distance from the first isolation opening overlays one first membrane opening, wherein two adjacent second isolation openings located at the first distance from each other overlay two second membrane openings.

10. Method according to the preceding claim, wherein the first isolation opening and first adjacent isolation opening are located on a first line, and wherein the two adjacent second isolation openings are located on a second line, the second line extending parallel to the first line, wherein each of the first isolation opening, the first adjacent isolation opening and the two adjacent second isolation openings is located on a different corner of a rectangular grid.

11. Method according to the claim 9 or 10, wherein the first membrane-to-open ratio is higher than zero, preferably 1:1, and wherein the second membrane-to-open ratio is 0:1.

12. Method according to claim 8, wherein the thin film membrane is free from other layers, and wherein the plurality of membrane openings are arranged in an array, wherein the irradiation beam has a beam projection for overlaying a row of membrane openings, the beam projection having a beam width and a beam height, the beam width being at least equal to the sum of the first distance and two membrane openings diameters, the beam height being at least equal to a membrane opening diameter, the method comprising shifting the beam projection in a direction transverse to the row of membrane openings for obtaining a plurality of diffraction patterns.

13. Method according to any one of claims 6-10, wherein the membrane openings are circular pinholes with a diameter of 8nm to 3μm.

14. Method according to any one of the preceding claims, wherein the radiation beam is an EUV light radiation beam.

15. Method according to any one of the preceding claims, wherein the image sensor and the associated membrane are located in a lithographic apparatus.

16. Image sensor system comprising:

- an image sensor comprising a detector;
- a membrane associated with the image sensor, wherein the membrane comprises a first patterned membrane section and a second patterned membrane section, wherein the first patterned membrane section has a first membrane-to-open ratio, and wherein the second patterned membrane section has a second membrane-to-open ratio, the second membrane-to-open ratio being different from the first membrane-to-open ratio,

wherein the detector is configured to, when the membrane is irradiated with a radiation beam, detect a first signal indicative of a first diffraction pattern of the first patterned membrane section, and to detect a second signal indicative of a second diffraction pattern of the second patterned membrane,
and wherein the detector is configured to provide the first signal and the second signal to a control system for determining the refractive index.

17. The image sensor system according to claim 16, further comprising the control system, the control system being configured to determine the refractive index of the membrane based on the first diffraction pattern and the second diffraction pattern.

18. Substrate stage comprising an image sensor system according to claim 16 or 17.

19. Lithographic apparatus configured for determining a refractive index of a membrane associated with an image sensor, the lithographic apparatus comprising:

- the image sensor comprising a detector,
- the membrane associated with the image sensor, wherein the membrane comprises a first patterned membrane section and a second patterned membrane section, wherein the first patterned membrane section has a first membrane-to-open ratio, and wherein the second patterned membrane section has a second membrane-to-open ratio, the second membrane-to-open ratio being different from the first membrane-to-open ratio,
- a radiation source for projecting a radiation beam on the first patterned membrane section and the second patterned membrane section,

wherein the detector is configured to detect a first signal indicative of a first diffraction pattern of the first patterned membrane section, and to detect a second signal indicative of a second diffraction pattern of the second patterned membrane,

and wherein the image sensor is configured to be coupled to a control system for determining the refractive index of the membrane based on the first diffraction pattern and the second diffraction pattern.

**FIG. 1**

**FIG. 2**

**Fig. 3**

**Fig. 4**

**Fig. 5A**

**Fig. 5B**

**Fig. 6A**

**Fig. 6B**

**Fig. 7A**

**Fig. 7B**

## Fig. 8

## Fig. 9

**Fig. 10**

**Fig. 11**

EP 4 733 842 A1

## Fig. 12

Europäisches
Patentamt
European
Patent Office
Office européen
des brevets

**EUROPEAN SEARCH REPORT**

Application Number

EP 24 20 8824

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2007 292509 A (SONY CORP) 8 November 2007 (2007-11-08) * paragraphs [0001] - [0009], [0102] - [0122]; claims 1,2 * ----- | 1-15 | INV. G03F7/20 G03F7/00 |
| A | US 2023/251407 A1 (CHONG DERICK YUN CHEK [NL] ET AL) 10 August 2023 (2023-08-10) * paragraphs [0092] - [0106], [0151] - [0163], [0218]; figures 2-4 * ----- | 1-15 | |

TECHNICAL FIELDS
SEARCHED     (IPC)

G03F

The present search report has been drawn up for all claims

| Place of search | Date of completion of the search | Examiner |
|---|---|---|
| Munich | 15 July 2025 | Roesch, Guillaume |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

..............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 20 8824

This annex lists the patent family members relating to the patent documents cited in the above-mentioned European search report.
The members are as contained in the European Patent Office EDP file on
The European Patent Office is in no way liable for these particulars which are merely given for the purpose of information.

15-07-2025

| Patent document cited in search report | | Publication date | Patent family member(s) | | Publication date |
|---|---|---|---|---|---|
| JP 2007292509 | A | 08-11-2007 | NONE | | |
| US 2023251407 | A1 | 10-08-2023 | CN | 115917279 A | 04-04-2023 |
| | | | EP | 3929555 A1 | 29-12-2021 |
| | | | KR | 20230025407 A | 21-02-2023 |
| | | | TW | 202208982 A | 01-03-2022 |
| | | | US | 2023251407 A1 | 10-08-2023 |
| | | | WO | 2021259745 A1 | 30-12-2021 |

EPO FORM P0459

For more details about this annex : see Official Journal of the European Patent Office, No. 12/82